# EUROPEAN PATENT SPECIFICATION

(11) **EP 2 725 684 B1**
(45) Date of publication and mention of the grant of the patent: **30.08.2017**
(21) Application number: 12788768.5
(22) Date of filing: 22.05.2012
(51) Int. Cl.: H02J 7/02, H01M 10/48, H02J 7/00, B60L 3/00, B60L 3/12, B60L 11/18, G01R 31/36, G01R 19/165

(54) **BATTERY DEVICE**
BATTERIEVORRICHTUNG
DISPOSITIF DE BATTERIE

(30) Priority: 25.05.2011 JP 2011116958
(43) Date of publication of application: 30.04.2014
(73) Proprietor: NEC Energy Devices, Ltd., Chuo-ku Sagamihara-shi Kanagawa 252-5298 (JP)
(72) Inventor: HORI, Yuuki, Sagamihara-shi Kanagawa 252-5298 (JP); SUZUKI, Shin, Sagamihara-shi Kanagawa 252-5298 (JP)
(74) Representative: Vossius & Partner Patentanwälte Rechtsanwälte mbB
(86) International application number: PCT/JP2012/063036
(87) International publication number: WO 2012/161186

(56) References cited:
- EP-A1- 0 609 101
- EP-A2- 0 977 047
- WO-A1-2007/145460
- JP-A- 6 283 210
- JP-A- 2002 142 370
- JP-A- 2004 312 867
- US-A1- 2009 078 481
- US-A1- 2010 259 270

## Description

The present invention relates to a storage battery device having a plurality of batteries and a charging and discharging method in the storage battery device.

Recently, environmental issues have attracted growing interest in various fields.

Among those, in the field of power supply, power supply by PV (Photo Voltanic) power generation, power supply utilizing secondary batteries for electric vehicles (EV: Electric Vehicle) and hybrid electric vehicles (HEV: Hybrid EV) and the like have been getting attention. As the secondary battery, the lithium ion secondary battery is regarded as the most likely candidate and expected to replace the lead storage battery with the spread in the future.

The storage battery element (storage battery) used as a secondary battery performs exchange of energy with the outside. Therefore, if the amount of energy to be exchanged becomes high, it is necessary to ensure battery safety by using protection circuits and the like.

Recently, in order to deal with the demand for high-voltage fields, multiple storage battery elements are connected in series to thereby gain high voltage.

As to storage battery elements connected in series, cases may occur in which the battery voltages of the storage battery elements differ from each other. This variation is caused by the different in characteristics between individual storage battery elements, the difference in temperature environment and the like. When storage battery elements that vary from each other are connected in series, the characteristic of the series body of batteries connected in series depends on the characteristic of the worst storage battery element.

To deal with this, techniques for making the voltage values of the storage batteries connected in series uniform have been tried (for example, see JP 2009-540793 A (Patent Document 1)).

EP 0 609 101 A1 discloses an electric power accumulating apparatus utilizing a parallel and/or serial array of plural secondary batteries, comprising means for detecting abnormality in each of the secondary batteries, means for electrically detaching the output terminals of the secondary battery showing abnormality and, in case of serial connection, shortcircuiting the terminals to which the secondary battery showing abnormality has been connected, and means for compensating the voltage corresponding to the detached battery.

US 2009/0078481 A1 describes a hybrid vehicle using multiple different modular battery units in the vehicle.

WO 2007/145460 A1 relates to a charge equalization apparatus with series-connected battery cells and, more particularly, to a charge equalization apparatus, in which series-connected battery cells are connected in parallel with the primary windings of transformers, switches for controlling the flow of current of the primary windings being connected in series with the primary windings, and multiple secondary windings corresponding to the primary windings are connected in parallel with each other.

US 2010/0259270 A1 describes a method for determining cell number, a cell number determination device, a power supply device and program, wherein a number of cells can be determined before control for a battery without providing cell number setting and input means.

Though it is possible by the technology disclosed in Patent Document 1 to reduce the possibility of occurrence of operation failure due to variation in the characteristics of storage battery elements, there is a problem that the technology cannot deal with a case where a part of storage battery elements has become deficient except for variation in characteristics.

In this case, the entire system including the series body becomes unusable, giving rise to a problem that all the battery elements have to be replaced by new ones in order to restore the battery.

The object of the present invention is to provide a storage battery device and a charging and discharging method for solving the above problems.

The storage battery device of the present invention is a storage battery device as defined by claim 1.

The charging and discharging method of the present invention is a charging and discharging method as defined by claim 13.

As has been described heretofore, according to the present invention, even if part of the storage batteries has become deficient, it is possible to continue charging and discharging, hence the life time of the system can be increased.

Next, the exemplary embodiments of the present invention will be described with reference to the drawings.
[FIG. 1] FIG. 1 is a diagram showing one exemplary embodiment of a storage battery device of the present invention
[FIG. 2] FIG. 2 is a diagram showing one example a threshold value stored in a storage unit shown in FIG. 1.
[FIG. 3] FIG. 3 is a diagram showing one example of an internal structure of a transformer shown in FIG. 1.
[FIG. 4] FIG. 4 is a table showing opening and closing states of switches in accordance with the conditions of batteries shown in FIG. 1.
[FIG. 5] FIG. 5 is a table showing opening and closing states of switches in accordance with the conditions of batteries shown in FIG. 1.
[FIG. 6] FIG. 6 is a diagram showing another exemplary embodiment of a storage battery device of the present invention.
[FIG. 7] FIG. 7 is a table showing opening and closing states of switches in accordance with the conditions of batteries shown in FIG. 6.

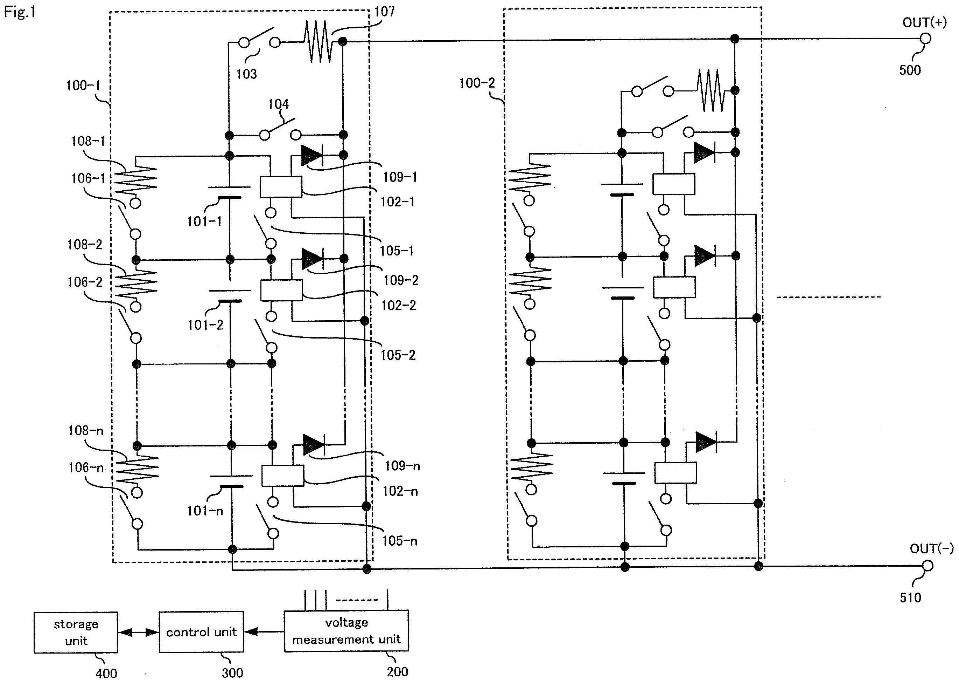

FIG. 1 is a diagram showing one exemplary embodiment of a storage battery device of the present invention.

As shown in FIG. 1, this exemplary embodiment includes a plurality of series bodies 100-1, 100-2, voltage measurement unit 200, control unit 300, storage unit 400, output terminal(+) 500, and output terminal(-) 510. Plural series bodies 100-1 and 100-2 are connected to each other in parallel. In FIG. 1, series body 100-1 and series body 100-2 alone are shown, but three or more series bodies may be connected to one another in parallel.

Series body 100-1 includes, as shown in FIG. 1, multiple storage batteries, i.e., batteries 101-1 to 101-n (n is a natural number equal to or greater than 2), transformers 102-1 to 102-n, switches 103, 104, 105-1 to 105-n, 106-1 to 106-n, resistors 107, 108-1 to 108-n, and diodes 109-1 to 109-n. The internal configuration of series body 100-2 is the same as that of series body 100-1.

Batteries 101-1 to 101-n are rechargeable storage batteries (storage battery elements). Batteries 101-1 to 101-n are lithium ion secondary batteries. Batteries 101-1 to 101-n are connected to each other in series.

Voltage measurement unit 200 measures the voltage value across each of batteries 101-1 to 101-n. Voltage measurement unit 200 outputs the measured voltage values to control unit 300. Voltage measurement unit 200 may be formed of a protective IC (Integrated Circuit) etc., and reads voltage across batteries 101-1 to 101-n by means of AD converters inside the IC.

Control unit 300 determines whether or not batteries 101-1 to 101-n are defective, based on the voltage values output from voltage measurement unit 200.

Herein, control unit 300 may compare the voltage value output from voltage measurement unit 200 with a predetermined threshold value and determine whether or not the battery is defective based on the result of comparison. For example, control unit 300 may be configured to determine that the battery is defective when the voltage value output from voltage measurement unit 200 is significantly lower than the threshold value or significantly higher than the threshold value.

For example, the control unit may be configured to determine that a battery is defective if the voltage across battery 101-1 to 101-n continues to be equal to or lower than 2V for 10 seconds or longer when batteries with a nominal capacity of 5Ah, a nominal internal impedance of 3 m Ω and a maximum rate of 5C are used as batteries 101-1 to 101-n. The voltage across the battery may momentarily lower to 2 V or below depending on the condition of discharging or other factors even if battery 101-1 to 101-n is normal. In such a case, use of the time average voltage makes it possible to avoid erroneous defective detection.

Alternatively, control unit 300 may be configured to compare the voltage values of batteries 101-1 to 101-n output from voltage measurement unit 200 and determine whether or not batteries are defective, based on the result of comparison. For example, control unit 300 may determine that a battery that has a voltage value that is widely different from the other voltage values is defective, among those of batteries 101-1 to 101-n output from voltage measurement unit 200.

An increase in the internal impedance of batteries 101-1 to 101-n indicates battery degradation. So, in order to detect the increase of impedance, it is possible to measure the voltage across each storage battery element during charging and discharging and calculate the median of the measurements in order to recognize that a storage battery element, in which the absolute value of the voltage difference from the median is equal to or greater than a predetermined value, is defective. For example, this predetermined value may be set at 75 mV (=5 Ah × 5C × 3 mΩ). With this configuration, even if part of storage battery elements have become defective, anomaly current (cross current) arising between series bodies due to the defective storage battery element can be reduced to be equal to or lower than the current corresponding to the maximum rate of the storage battery element. Here, if the voltage distribution of the storage battery elements is symmetrical, the same detection can be done using the arithmetic mean value for the median.

Alternatively, control unit 300 may be configured to determine whether a battery is defective based on the degree of fluctuation (instability) of the voltage values of batteries 101-1 to 101-n output from voltage measurement unit 200. For example, control unit 300 may be configured such that if, from among batteries 101-1 to 101-n, there is a battery in which the degree of fluctuation of the voltage value output from voltage measurement unit 200 exceeds the predetermined range, the battery is considered to be defective.

Instead of determining whether or not batteries 101-1 to 101-n are defective based on the voltage values of batteries 101-1 to 101-n measured by voltage measurement unit 200, it is possible to provide a temperature measurement unit which measures the temperature of batteries 101-1 to 101-n and determines whether or not batteries 101-1 to 101-n are defective based on the measured temperatures. In this case, the control unit may be configured to determine that a battery is defective when the temperature measured by voltage measurement unit 200 is significantly higher than a predetermined threshold temperature (or may be stored in storage unit 400), when significantly lower (when equal to or higher than the predetermined value set at 70 deg.C, for example), when unstable, or when the temperature has abruptly risen or fallen. With this configuration, it is possible to prevent abnormal heating up of batteries 101-1 to 101-n. If it is difficult for the temperature measurement unit to measure the internal temperature of batteries 101-1 to 101-n, the temperature measurement unit may measure the external temperature of batteries 101-1 to 101-n. In other words, any temperature measurement unit is permissible as long as it measures temperature at a predetermined part of batteries 101-1 to 101-n.

It is also possible to determine whether or not batteries 101-1 to 101-n are defective based on both the voltage values measured by voltage measurement unit 200 and the temperatures measured by the temperature measurement unit.

When there is no battery which was determined to be defective from the above result of determination, control unit 300 outputs the series voltage across batteries 101-1 to 101-n as the output voltage of series body 100-1. On the other hand, when there is a battery which was determined to be defective, based on the above result, control unit 300 outputs the boosted voltage from the voltage of the batteries, other than the battery that was determined as a defective, as the output voltage of series body 100-1.

Specifically, when there is no battery which was determined as a defective in series body 100-1 based on the above result, control unit 300 disconnects transformers 102-1 to 102-n from series body 100-1. On the other hand, when there is a battery which was determined as a defective in series body 100-1, based on the above result, control unit 300 disconnects the battery that was determined as a defective and the transformer connected to that battery from series body 100-1 and boosts the output voltage of the batteries, other than the battery that was determined as a defective, using transformers 102-1 to 102-n and outputs the boosted voltage. That is, the discharge path of the battery that was determined as a defective is shut down.

In this way, if part of the batteries that constitute a series body has become defective, controller 300 disconnects the battery that was determined as a defective from the series body and boosts the voltage of the other batteries to be output, so that the series body in question can continue to discharge whilst remaining connected the other normal series bodies. As a result, it is possible to keep the battery device in operation without applying loads on the normal series bodies, compared to the case where part of the batteries for a series body being defective is cut off from the series body.

Storage unit 400 stores the threshold values to be used for the determination process of control unit 300 beforehand.

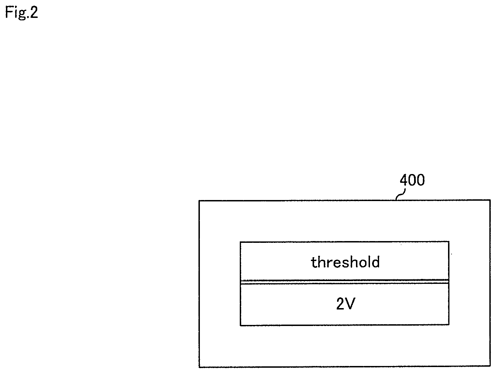

FIG. 2 is a diagram showing one example of a threshold value being stored in storage unit 400 shown in FIG. 1.

Storage unit 400 shown in FIG. 1 holds a threshold value to be used for the determination process, as shown in FIG. 2. For example, as shown in FIG. 2, a threshold value "2V" is stored. In this case, control unit 300 determines whether or not batteries 101-1 to 101-n are defective, using this threshold value.

Transformers 102-1 to 102-n are transformers (e.g., DC-DC converters or the like) that are connected to batteries 101-1 to 101-n, respectively so as to be able to boost the voltage of batteries 101-1 to 101-n. Transformers 102-1 to 102-n are each formed of two coils, the primary coil connected in parallel to corresponding battery 101-1 to 101-n and the secondary coil connected in parallel to series body 100-1. Here, though the term "coil" is used, the transformer does not need to be formed of coils as long as it can boost or step down the voltage applied on the primary side (on the left side in FIG. 1) and output the boosted or step-down voltage to the secondary side (the right side in FIG. 1).

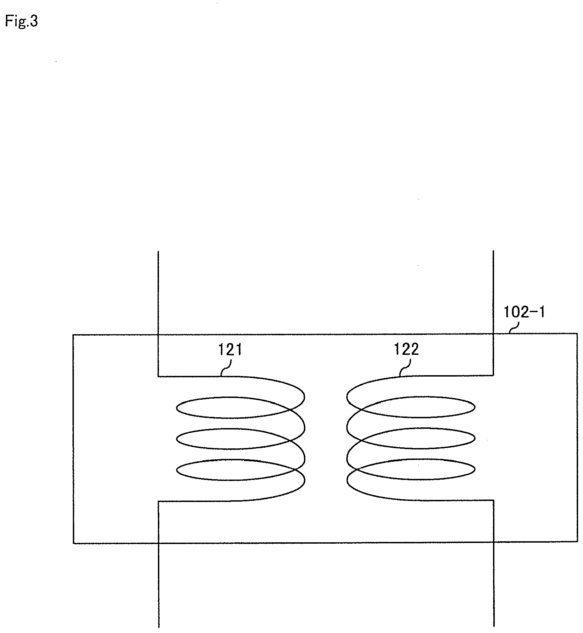

FIG. 3 is a diagram showing one example of an internal configuration of transformer 102-1 shown in FIG. 1.

As shown in FIG. 3, transformer 102-1 shown in FIG. 1 is a transformer formed of primary coil 121 and secondary coil 122. Transformer 102-1 boosts the voltage applied across primary coil 121 and outputs the boosted voltage to the secondary coil 122 side. The ratio of the number of turns in secondary coil 122 to that in the primary coil 121 is the number of batteries belonging to one series body 100-1 (n, in this case). That is, when the number of batteries is n, the ratio between the number of turns in the primary coil and that in the secondary coil is l:n.

Transformers 102-1 to 102-n may be those that can variably convert the voltage value such as DCDC converters or the like.

Here, the internal configuration of transformers 102-2 to 102-n shown in FIG. 1 is the same as that of transformer 102-1 shown in FIG. 3.

Switch 103 is a current limiting path switch.

Switch 104 is a first discharge switch that is connected in series with batteries 101-1 to 101-n to switch connection (short-circuit)/disconnection under instructions from control unit 300.

Switches 105-1 to 105-n are second discharge switches that are connected in series with the primary coils of transformers 102-1 to 102-n, respectively, to switch connection (short-circuit)/disconnection under instructions from control unit 300.

Switches 106-1 to 106-n are switches that are connected in parallel with batteries 101-1 to 101-n, receptively to switch connection (short-circuit)/disconnection under instructions from control unit 300 at the time of charging batteries 101-1 to 101-n.

Herein, "connection (short-circuit)" is a state in which the switch is physically closed, and "disconnection" is a state in which the switch is physically open.

Control unit 300 performs the above-described control by instructing these switches to connect (short-circuit)/ open. Specifically, when there is no battery that was determined to be defective at the time when batteries 101-1 to 101-n are being discharged, control unit 300 short-circuits switch 104 and opens all of switches 105-1 to 105n. On the other hand, when there is a battery that was determined to be defective at the time when batteries 101-1 to 101-n are being discharged, control unit 300 opens switch 104 and switch 105 that is connected to the primary coil of the transformer connected to the battery that was determined as a defective, and short-circuits the switches 105 connected to the primary coils of the transformers other than the former transformer. When there is no battery that was determined as a defective at the time when batteries 101-1 to 101-n are being discharged and being charged, control unit 300 opens switch 103. On the other hand, when there is a battery that was determined as a defective at the time when batteries 101-1 to 101-n are being discharged, control unit 300 opens switch 103. Further, when there is a battery that was determined to be defective at the time when batteries 101-1 to 101-n are being charged, control unit 300 short-circuits switch 103.

Further, when charging batteries 101-1 to 101-n, control unit 300 short-circuits switch 106 connected to the battery that was determined to be defective and opens switches 106 other than that. In a word, a bypass route is formed in order to ensure safety of the battery that was determined to be defective.

Moreover, control unit 300 may be configured to give notice to a predetermined device or perform a predetermined display in order that the system operator and others can recognize the above result of determination or the opening and closing operation of switches.

Resistor 107 is a current limiting resistor connected in series with switch 103. The set of switch 103 and resistor 107 may be replaced by a low current circuit that is made up of IGBT (Insulated Gate Bipolar Transistor), typical transistors and the like.

Resistors 108-1 to 108-n are bypass resistors connected in series with switches 106-1 to 106-n, respectively.

Diodes 109-1 to 109-n are each a reverse current protecting device connected in series with the secondary coil of respective transformer 102-1 to 102-n.

Here, switches 103, 104 and resistor 107 may be disposed on either the positive side or the negative side of series body 100-1.

Output terminal(+) 500 and output terminal(-) 510 are terminals that respectively output the positive potential and negative potential of series bodies 100-1 to 100-n.

Here, switches 103, 104, 105-1 to 105-n, and 106-1 to 106-n are switching devices such as MOS-FETs, transistors, and relays.

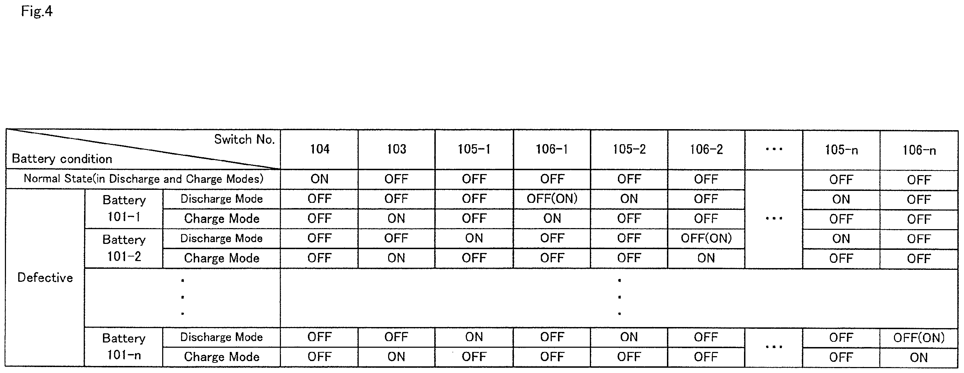

FIG. 4 is a table showing switching states in accordance with the conditions of batteries 101-1 to 101-n shown in FIG. 1.

In FIG. 4, the open(OFF) state and the closed(ON) state of switches 103, 104, 105-1 to 105-n, and 106-1 to 106-n in accordance with the conditions of batteries 101-1 to 101-n shown in FIG. 1, are shown and classified into those states at the time of discharging and at the time of charging.

When batteries 101-1 to 101-n are all normal, at the time of being discharged and at the time of being charged control unit 300 controls such that switch 104 is turned ON while the other switches 103, 105-1 to 105-n, 106-1 to 106-n are turned OFF.

When it is determined that battery 101-1 is defective at the time of being discharged, control unit 300 controls such that switches 105-2 to 105-n are turned ON while the other switches 103, 104, 105-1, 106-1 to 106-n are turned OFF. Herein, control unit 300 may control such that switch 106-1 is turned ON.

When it is determined that battery 101-1 is defective at the time of being charged, control unit 300 controls such that switches 103 and 106-2 to 106-n are turned OFF.

When it is determined that battery 101-2 is defective at the time of being discharged, control unit 300 controls such that switches 105-1, 105-3 (not shown) to 105-n are turned ON while the other switches 103, 104, 105-2, 106-1 to 106-n are turned OFF. Herein, control unit 300 may control such that switch 106-2 is turned ON.

When it is determined that battery 101-2 is defective at the time of being charged, control unit 300 controls such that switches 103 and 106-2 are turned ON while the other switches 104, 105-1 to 105-n, 106-1, 106-3 (not shown) to 106-n are turned OFF.

When it is determined that battery 101-n is defective at the time of being discharged, control unit 300 controls such that switches 105-1 to 105-(n-1) (not shown) are turned ON while the other switches 103, 104, 105-n, 106-1 to 106-n are turned OFF. Herein, control unit 300 may control such that switch 106-n is turned ON.

When it is determined that battery 101-n is defective at the time of being charged, control unit 300 controls such that switches 103 and 106-n are turned ON while the other switches 104, 105-1 to 105-n, 106-1 to 106-(n-1)(not shown) are turned OFF.

When there is a battery that was determined to be defective candidate in addition to determination of defective, the same procedure may be done. Defining the method of using defective candidates also makes it possible to increase the life time of the electricity storage system.

This defective candidate means one that is not defective but is going to be defective.

For example, any of batteries 101-1 to 101-n whose difference in voltage therebetween at the time of being charged and at the time of being discharged is equal to or greater than 45 mV and less than 75 mV may be regarded as a defective candidate. It is also possible to detect based on the voltage difference in open-circuit voltage from each other among batteries 101-1 to 101-n. In this case, similarly to detection of a defective, those presenting a voltage difference of 75 mV or greater may be regarded as a defective candidate. With this, it is possible to prevent occurrence of excessive cross current.

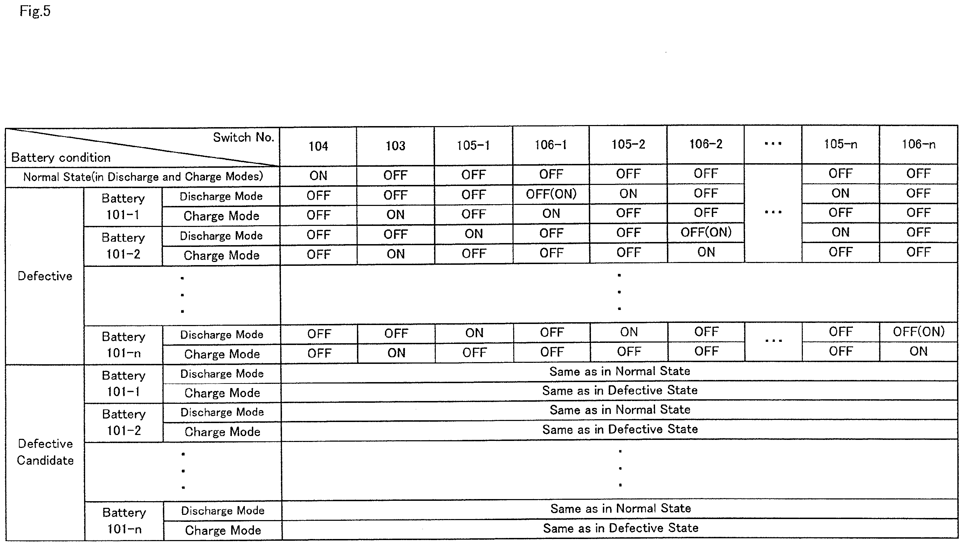

FIG. 5 is a table showing switching states in accordance with the conditions of batteries 101-1 to 101-n shown in FIG. 1.

In FIG. 5, the open(OFF) state and the closed(ON) state of switches 103, 104, 105-1 to 105-n, and 106-1 to 106-n in accordance with the conditions of batteries 101-1 to 101-n shown in FIG. 1, are shown and classified into those at the time of being discharged and at the time of being charged. Further, in FIG. 5, the conditions of batteries 101-1 to 101-n are shown with normal, defective, or defective candidate.

The open(OFF) and closed(ON) states of switches 103, 104, 105-1 to 105-n, and 106-1 to 106-n when the conditions of batteries 101-1 to 101-n are normal and defective are the same as those explained with FIG. 4.

When it is determined that battery 101-1 is a defective candidate at the time of being discharged, control unit 300 controls the switching states of switches 103, 104, 105-1 to 105-n and 106-1 to 106-n in the same manner when the conditions are normal.

When it is determined that battery 101-1 is a defective candidate at the time of being charged, control unit 300 controls the switching states of switches 103, 104, 105-1 to 105-n and 106-1 to 106-n in the same manner when the condition of battery 101-1 is determined to be defective.

When it is determined that battery 101-2 is a defective candidate at the time of being discharged, control unit 300 controls the switching states of switches 103, 104, 105-1 to 105-n and 106-1 to 106-n in the same manner when the conditions are normal.

When it is determined that battery 101-2 is a defective candidate at the time of being charged, control unit 300 controls the switching states of switches 103, 104, 105-1 to 105-n and 106-1 to 106-n in the same manner when the condition of battery 101-2 is determined to be defective.

When it is determined that battery 101-n is a defective candidate at the time of being discharged, control unit 300 controls the switching states of switches 103, 104, 105-1 to 105-n and 106-1 to 106-n in the same manner when the conditions are normal.

When it is determined that battery 101-n is a defective candidate at the time of being charged, control unit 300 controls the switching states of switches 103, 104, 105-1 to 105-n and 106-1 to 106-n in the same manner when the condition of battery 101-n is determined to be defective.

With this control it is possible to exclude storage battery elements that are highly likely to become defective, beforehand.

Further, the transformers may be those that can boost or step down voltage in both directions.

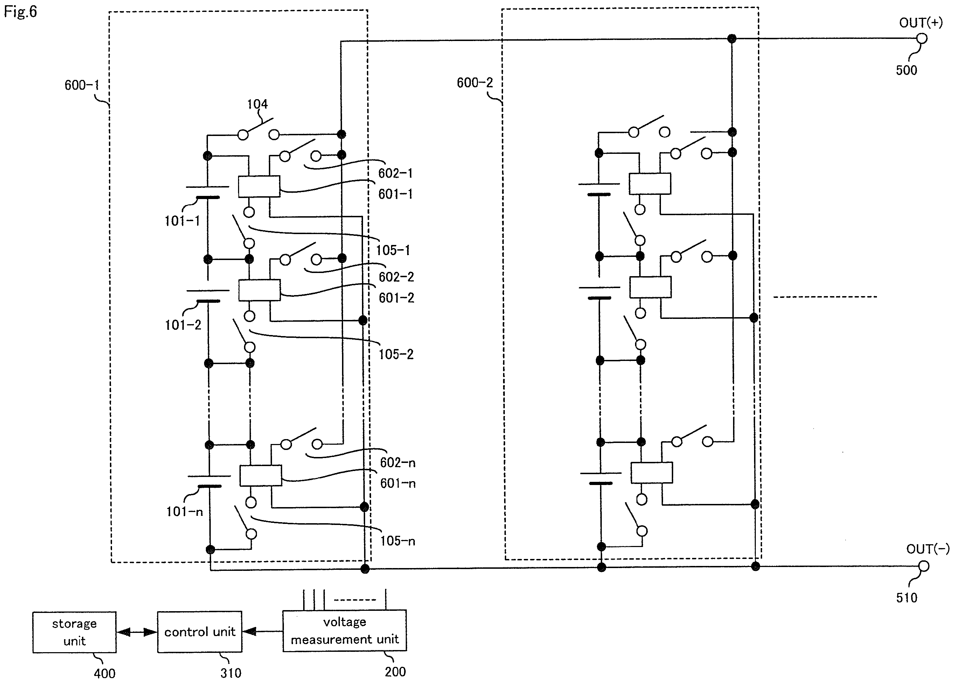

FIG. 6 is a diagram showing another exemplary embodiment of a storage battery device of the present invention.

As shown in FIG. 6, this embodiment includes a plurality of series bodies 600-1, 600-2, voltage measurement unit 200, control unit 310, storage unit 400, output terminal(+) 500, and output terminal(-) 510. Plural series bodies 600-1 and 600-2 are connected to each other in parallel. In FIG. 6, series body 600-1 and series body 600-2 alone are shown, but three or more series bodies may be connected to one another in parallel.

Voltage measurement unit 200, storage unit 400, output terminal(+) 500 and output terminal(-) 510 are the same as those in FIG. 1.

Series body 600-1 includes, as shown in FIG. 6, multiple storage batteries, i.e., batteries 101-1 to 101-n, transformers 601-1 to 601-n, switches 104, 105-1 to 105-n, and 602-1 to 602-n. Here, the internal configuration of series body 600-2 is the same as that of series body 600-1.

Batteries 101-1 to 101-n, and switches 104, 105-1 to 105-n are the same as those shown in FIG. 1. In the embodiment shown in FIG. 6, switch 104 is the third discharge switch and switches 105-1 to 105-n are the fourth discharge switches.

Transformers 601-1 to 601-n are transformers (e.g., DC-DC converters or the like) that are connected to batteries 101-1 to 101-n, respectively so as to be able to boost or step down voltage in both directions. Transformers 601-1 to 601-n are each formed of two coils, the primary coil connected in parallel to corresponding battery 101-1 to 101-n and the secondary coil connected in parallel to series body 600-1. Here, though the term "coil" is used, the transformer does not need to be formed of coils as long as it can boost or step down the voltage applied on the primary side (on the left side in FIG. 6) and output the boosted or step-down voltage to the secondary side (the right side in FIG. 6) and can boost or step down the voltage applied on the secondary side and output the boosted or step-down voltage to the primary side.

Switches 602-1 to 602-1 are the fifth discharge switches that are each connected in series with the secondary coil of corresponding transformer 601-1 to 601-n.

Control unit 310 determines whether or not batteries 101-1 to 101-n are defective, based on the voltage values output from voltage measurement unit 200. The criteria for determination may be the same as those in control unit 300 shown in FIG. 1.

When there is no battery which is determined to be defective from the above result of determination, control unit 310 outputs the series voltage across batteries 101-1 to 101-n as the output voltage of series body 600-1. On the other hand, when there is a battery which was determined to be defective from the above result of determination, control unit 310 outputs the boosted voltage from the voltage of the batteries other than the battery that was determined to be defective, as the output voltage of series body 600-1.

Specifically, when there is no battery which was determined to be defective in series body 600-1 from the above result of determination, control unit 310 disconnects transformers 601-1 to 601-n from series body 600-1. On the other hand, when there is a battery which was determined to be defective in series body 600-1 from the above result of determination, control unit 310 disconnects the battery that was determined to be defective and the transformer connected to that battery from series body 600-1 and boosts the output voltage of the batteries other than the battery that was determined to be defective, using transformers 601-1 to 601-n and outputs the boosted voltage. That is, the charge and discharge path of the battery that was determined to be defective is shut down.

Control unit 310 performs the above-described control by instructing these switches to connect (short-circuit)/open. Specifically, when there is no battery that was determined to be defective, control unit 310 short-circuits switch 104 and opens all of switches 105-1 to 105n and 602-1 to 602-n. On the other hand, when there is a battery that was determined as a defective, control unit 310 opens switch 104 and the switches 105 and 602 that are respectively connected to the primary coil and the secondary coil of the transformer connected to the battery that was determined to be defective, and short-circuits the switches 105 and 602 connected to the primary coils and secondary coils of the transformers other than the former transformer.

Moreover, control unit 310 may be configured to give notice to a predetermined device or perform a predetermined display in order that the system operator and others can recognize the above result of determination and the opening and closing operation of switches.

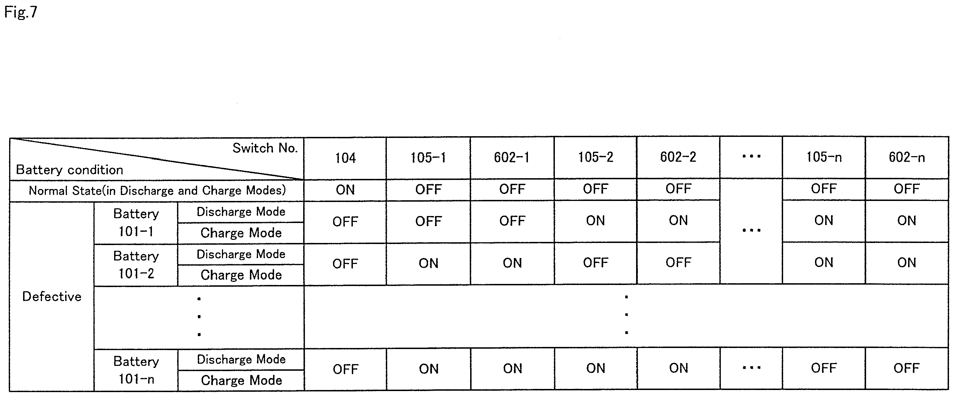

FIG. 7 is a table showing switching states in accordance with the conditions of batteries 101-1 to 101-n shown in FIG. 6.

In FIG. 7, the open(OFF) state and the closed(ON) state of switches 104, 105-1 to 105-n, and 602-1 to 602-n in accordance with the conditions of batteries 101-1 to 101-n shown in FIG. 6, are shown and classified into those at the time of being discharged and at the time of being charged.

When batteries 101-1 to 101-n are all normal, at the time of being discharged and at the time of being charged,control unit 310 controls such that switch 104 is turned ON while the other switches 105-1 to 105-n, 602-1 to 602-n are turned OFF.

When it is determined that battery 101-1 is defective, at the time of being discharged and at the time of being charged, control unit 310 controls such that switches 104, 105-1 and 602-1 are turned OFF while the other switches 105-2 to 105-n and 602-2 to 602-n are turned ON.

When it is determined that battery 101-2 is defective, at the time of being discharged and at the time of being charged,control unit 310 controls such that switches 104, 105-2 and 602-2 are turned OFF while the other switches 105-1, 105-3 (not shown) to 105-n, 602-1 and 602-3 (not shown) to 602-n are turned ON.

When it is determined that battery 101-n is defective, at the time of being discharged and at the time of being charged,control unit 310 controls such that switches 104, 105-n and 602-2 are turned OFF while the other switches 105-1 to 105-(n-1) (not shown), 602-1 to 602-(n-1) (not shown) are turned ON.

Instead of allotting one transformer for one battery, battery groups may be formed of multiple batteries so that one transformer is allotted for each battery group.

Here, the voltage values and temperature to be the criteria for detection of defectives and candidates may be changed as appropriate depending on the material and voltage range of storage battery elements.

As described heretofore, instead of cutting off the whole series body including a battery that was determined to be defective, the defective battery alone is cut off and the other batteries are used for output by boosting voltage. Accordingly, instead of being disqualified, the series body including the defective battery can be used as an auxiliary for the other normal series bodies. As a result, it becomes possible to prevent a marked lowering of the system capacity, reduce the number of times of changing a new battery, and inhibit degradation due to rate increase of the remaining series bodies, thus making it possible to lengthen the life of the whole system. Further, even if part of the batteries has become deficient, it is possible to keep the system running without stoppage.

Further, by cutting off a battery that was determined to be defective, it is possible to prevent the battery from exerting adverse influence on the other normal batteries.

Although the present invention has been explained with reference to the exemplary embodiments, the present invention should not be limited to the above exemplary embodiments of the invention. Various modifications that can be understood by those skilled in the art may be made to the structure and details of the present invention within the scope of the present invention.

This application claims priority based on Japanese Patent Application No. 2011-116958, filed on May 25, 2011.

## Claims

1. A storage battery device including a plurality of storage batteries (101-1 to 101-n), and including a plurality of parallel connected series bodies (100-1, 100-2), each formed of multiple storage batteries (101-1 to 101-n) being connected in series, each of the series bodies (100-1) comprises:
a voltage measurement unit (200) for measuring the voltage value between both ends of each of the multiple storage batteries (101-1 to 101-n),
a plurality of transformers (102-1 to 102-n) which, each being associated with a corresponding one of the multiple storage batteries (101-1 to 101-n), each having a primary side connected in parallel to the corresponding one of the multiple storage batteries (101-1 to 101-n) and a secondary side connected in parallel to the series body (100-1), is adapted to boost the input voltage of the primary side and output the boosted voltage to the secondary side, and,
a control unit (300) adapted to determine whether or not the storage batteries (101-1 to 101-n) are defective based on the voltage values measured by the voltage measurement unit (200) and when there is no storage battery that was determined to be defective, to disconnect the multiple transformers (102-1 to 102-n) from the series body (100-1) and to output the series voltage of the multiple storage batteries (101-1 to 101-n) as an output voltage of the series body (100-1) and when there is a storage battery that was determined to be defective, to disconnect the storage battery and the transformer that is connected to the storage battery and to boost the output voltage of the storage batteries other than the defective battery using the transformers and to output the boosted voltage as the output voltage of the series body (100-1).

2. The storage battery device according to Claim 1,
**characterized in that**
the series body (100-1) comprises:
a first discharge switch (104) connected in series with the storage batteries (101-1 to 101-n); and,
a plurality of second discharge switches (105-1 to 105-n) each connected in series with the primary side of each of the multiple transformers (102-1 to 102-n),
at the time of being discharged, the control unit (300), when there is no storage battery that was determined to be defective, short-circuits the first discharge switch (104) and opens all the second discharge switches (105-1 to 105-n), and when there is a storage battery that was determined to be defective, opens the first discharge switch (104) and the second discharge switch connected to the primary side of the transformer that is connected to the storage battery that was determined to be defective and short-circuits the second discharge switches connected to the primary sideof the transformers other than the transformer that is connected to the storage battery that was determined to be defective.

3. The storage battery device according to Claim 1 or 2, **characterized in that**
the series body (100-1) comprises a plurality of charging switches (106-1 to 106-n)connected in parallel with each of the multiple storage batteries (101-1 to 101-n), and
the control unit (300), at the time of charging the storage batteries (101-1 to 101-n), short-circuits the charging switch connected to the battery determined to be defective and opens the charging switches other than that.

4. The storage battery device according to Claim 1, **characterized in that** the transformer (102-1 to 102-n) can boost or step down voltage in both directions.

5. The storage battery device according to Claim 4, **characterized in that**
the series body (100-1) comprises a third discharge switch connected in series with the storage batteries (101-1 to 101-n), a plurality of fourth discharge switches each connected in series with the primary side of each of the multiple transformers (102-1 to 102-n), and a plurality of fifth discharge switches each connected in series with the secondary side of each of the multiple transformers (102-1 to 102-n),
the control unit (300), when there is no storage battery that was determined to be defective, short-circuits the third discharge switch and opens all the fourth discharge switches and the fifth discharge switches, and when there is a storage battery that was determined to be defective, opens the third discharge switch and the fourth discharge switch and the fifth discharge switch which are respectively connected to the primary side and the secondary side of the transformer that is connected to the storage battery that was determined to be defective and short-circuits the fourth discharge switches and fifth discharge switches connected to the primary side and secondary side of the transformers other than the transformer that is connected to the storage battery that was determined to be defective.

6. The storage battery device according to Claim 1, **characterized in that** the ratio of the output voltage from the secondary side to the input voltage from the primary side is the number of batteries belonging to one series body (100-1, 100-2).

7. The storage battery device according to any one of Claims 1 to 6, **characterized in that** the control unit (300) compares the voltage value measured by the voltage measurement unit (200) with a predetermined threshold value and determines whether or not the battery is defective based on the result of comparison.

8. The storage battery device according to any one of Claims 1 to 7, **characterized in that** the control unit (300) compares the voltage values of the multiple storage batteries (101-1 to 101-n) measured by the voltage measurement unit (200) and determines whether or not the storage batteries (101-1 to 101-n) are defective based on the result of comparison.

9. The storage battery device according to Claim 3, **characterized in that** the control unit (300), at the time of charging the storage batteries (101-1 to 101-n), determines whether or not the storage batteries (101-1 to 101-n) are defective candidates based on the voltage values measured by the voltage measurement unit (200), and short-circuits the charging switch connected to the storage battery that was detected as a defective candidate and opens the charge switches other than that.

10. The storage battery device according to Claim 9, **characterized in that** the control unit (300) compares the voltage values of the multiple storage batteries (101-1 to 101-n) measured by the voltage measurement unit (200) and determines whether or not the storage batteries (101-1 to 101-n) are defective candidates based on the result of comparison.

11. The storage battery device according to any one of Claims 1 to 10, **characterized in that** the storage battery (101-1 to 101-n) is a lithium ion secondary battery.

12. The storage battery device according to any one of Claims 1 to 11, **characterized in that** each of the storage batteries is a battery group which includes the multiple storage batteries being connected in series.

13. A charging and discharging method for charging and discharging storage batteries in a storage battery device having a plurality of series bodies (100-1, 100-2) which are connected in parallel and include a plurality of storage batteries (101-1 to 101-n) connected in series and a plurality of transformers (102-1 to 102-n) which, each being associated with a corresponding one of the multiple storage batteries(101-1 to 101-n), each having the primary side connected in parallel to the corresponding one of the multiple storage batteries (101-1 to 101-n) and the secondary side connected in parallel to the series body (100-1, 100-2), boost the input voltage of the primary side and output the boosted voltage to the secondary side, comprising the steps of:
measuring the voltage value between both ends of each of the multiple storage batteries(101-1 to 101-n);
determining whether or not the storage batteries (101-1 to 101-n) are defective based on the measured voltage values;
disconnecting the multiple transformers (102-1 to 102-n) from the series body (100-1) and outputting the series voltage of the multiple storage batteries (101-1 to 101-n) as the output voltage of the series body (100-1) when there is no storage battery that was determined to be defective; and,
disconnecting the storage battery and the transformer that is connected to the storage battery and boosts the output voltage of the storage batteries other than the defective battery using the transformers and outputting the boosted as the output voltage of the series body (100-1) when there is a storage battery that was determined to be defective.

## Patentansprüche

1. Speicherbatterievorrichtung, die mehrere Speicherbatterien (101-1 bis 101-n) aufweist und Folgendes aufweist:
mehrere parallel geschaltete Reihenkörper (100-1, 100-2), die jeweils aus mehreren in Reihe geschalteten Speicherbatterien (101-1 bis 101-n) gebildet sind,
wobei jeder der Reihenkörper (100-1) Folgendes aufweist:
eine Spannungsmesseinheit (200) zum Messen des Spannungswerts zwischen beiden Enden jeder der mehreren Speicherbatterien (101-1 bis 101-n),
mehrere Transformatoren (102-1 bis 102-n), die jeweils einer entsprechenden der mehreren Speicherbatterien (101-1 bis 101-n) zugeordnet sind, und jeweils eine Primärseite, die parallel zur entsprechenden der mehreren Speicherbatterien (101-1 bis 101-n) geschaltet ist, und eine Sekundärseite, die parallel zum Reihenkörper (100-1) geschaltet ist, aufweisen und dafür eingerichtet sind, die Eingangsspannung der Primärseite zu verstärken und die verstärkte Spannung auf der Sekundärseite auszugeben, und
eine Steuereinheit (300), die dafür eingerichtet ist, auf der Grundlage der von der Spannungsmesseinheit (200) gemessenen Spannungswerte festzustellen, ob die Speicherbatterien (101-1 bis 101-n) fehlerhaft sind, und, wenn festgestellt wird, dass keine Speicherbatterie fehlerhaft ist, die mehreren Transformatoren (102-1 bis 102-n) vom Reihenkörper (100-1) zu trennen und die Reihenspannung der mehreren Speicherbatterien (101-1 bis 101-n) als Ausgangsspannung des Reihenkörpers (100-1) auszugeben, und, wenn festgestellt wird, dass es eine Speicherbatterie gibt, die fehlerhaft ist, die Speicherbatterie und den mit der Speicherbatterie verbundenen Transformator zu trennen und die Ausgangsspannung der Speicherbatterien mit Ausnahme der fehlerhaften Batterie unter Verwendung der Transformatoren zu verstärken und die verstärkte Spannung als Ausgangsspannung des Reihenkörpers (100-1) auszugeben.

2. Speicherbatterievorrichtung nach Anspruch 1, **dadurch gekennzeichnet, dass**
der Reihenkörper (100-1) Folgendes aufweist:
einen ersten Entladeschalter (104), der in Reihe mit den Speicherbatterien (101-1 bis 101-n) geschaltet ist, und
mehrere zweite Entladeschalter (105-1 bis 105-n), die jeweils in Reihe mit der Primärseite jedes der mehreren Transformatoren (102-1 bis 102-n) geschaltet sind,
wobei, während entladen wird, die Steuereinheit (300), wenn festgestellt wird, dass keine Speicherbatterie fehlerhaft ist, den ersten Entladeschalter (104) kurzschließt und alle zweiten Entladeschalter (105-1 bis 105-n) öffnet und, wenn festgestellt wird, dass es eine fehlerhafte Speicherbatterie gibt, den ersten Entladeschalter (104) und den zweiten Entladeschalter, der mit der Primärseite des Transformators verbunden ist, welcher mit der Speicherbatterie verbunden ist, welche als fehlerhaft festgestellt wurde, öffnet und die zweiten Entladeschalter, die mit der Primärseite der Transformatoren mit Ausnahme des Transformators verbunden sind, der mit der Speicherbatterie verbunden ist, welche als fehlerhaft festgestellt wurde, kurzschließt.

3. Speicherbatterievorrichtung nach Anspruch 1 oder 2, **dadurch gekennzeichnet, dass**
der Reihenkörper (100-1) mehrere Ladeschalter (106-1 bis 106-n) aufweist, die parallel zu jeder der mehreren Speicherbatterien (101-1 bis 101-n) geschaltet sind, und
die Steuereinheit (300) während des Ladens der Speicherbatterien (101-1 bis 101-n) den Ladeschalter, der mit der Batterie verbunden ist, die als fehlerhaft festgestellt wurde, kurzschließt und die anderen Ladeschalter öffnet.

4. Speicherbatterievorrichtung nach Anspruch 1, **dadurch gekennzeichnet, dass** der Transformator (102-1 bis 102-n) die Spannung in beiden Richtungen verstärken oder abschwächen kann.

5. Speicherbatterievorrichtung nach Anspruch 4, **dadurch gekennzeichnet, dass**
der Reihenkörper (100-1) einen dritten Entladeschalter, der in Reihe mit den Speicherbatterien (101-1 bis 101-n) geschaltet ist, mehrere vierte Entladeschalter, die jeweils in Reihe mit der Primärseite jedes der mehreren Transformatoren (102-1 bis 102-n) geschaltet sind, und mehrere fünfte Entladeschalter, die jeweils in Reihe mit der Sekundärseite jedes der mehreren Transformatoren (102-1 bis 102-n) geschaltet sind, aufweist,
wobei die Steuereinheit (300), wenn festgestellt wird, dass keine Speicherbatterie fehlerhaft ist, den dritten Entladeschalter kurzschließt und alle vierten und fünften Entladeschalter öffnet, und, wenn festgestellt wird, dass es eine fehlerhafte Speicherbatterie gibt, den dritten Entladeschalter und den vierten Entladeschalter sowie den fünften Entladeschalter, die jeweils mit der Primärseite und der Sekundärseite des Transformators verbunden sind, der mit der Speicherbatterie verbunden ist, die als fehlerhaft festgestellt wurde, öffnet und die vierten und fünften Entladeschalter, die mit der Primärseite und der Sekundärseite der Transformatoren mit Ausnahme des Transformators verbunden sind, der mit der Speicherbatterie verbunden ist, welche als fehlerhaft festgestellt wurde, kurzschließt.

6. Speicherbatterievorrichtung nach Anspruch 1, **dadurch gekennzeichnet, dass** das Verhältnis zwischen der Ausgangsspannung von der Sekundärseite und der Eingangsspannung von der Primärseite gleich der Anzahl der zu einem Reihenkörper (100-1, 100-2) gehörenden Batterien ist.

7. Speicherbatterievorrichtung nach einem der Ansprüche 1 bis 6, **dadurch gekennzeichnet, dass** die Steuereinheit (300) den von der Spannungsmesseinheit (200) gemessenen Spannungswert mit einem vorgegebenen Schwellenwert vergleicht und auf der Grundlage des Vergleichsergebnisses feststellt, ob die Batterie fehlerhaft ist.

8. Speicherbatterievorrichtung nach einem der Ansprüche 1 bis 7, **dadurch gekennzeichnet, dass** die Steuereinheit (300) die von der Spannungsmesseinheit (200) gemessenen Spannungswerte der mehreren Speicherbatterien (101-1 bis 101-n) vergleicht und auf der Grundlage des Vergleichsergebnisses feststellt, ob die Speicherbatterien (101-1 bis 101-n) fehlerhaft sind.

9. Speicherbatterievorrichtung nach Anspruch 3, **dadurch gekennzeichnet, dass** die Steuereinheit (300) während des Ladens der Speicherbatterien (101-1 bis 101-n) auf der Grundlage der von der Spannungsmesseinheit (200) gemessenen Spannungswerte feststellt, ob die Speicherbatterien (101-1 bis 101-n) fehlerhaft sind, und den Ladeschalter kurzschließt, der mit der Speicherbatterie verbunden ist, die als ein Fehlerkandidat festgestellt wurde, und die anderen Ladeschalter öffnet.

10. Speicherbatterievorrichtung nach Anspruch 9, **dadurch gekennzeichnet, dass** die Steuereinheit (300) die von der Spannungsmesseinheit (200) gemessenen Spannungswerte der mehreren Speicherbatterien (101-1 bis 101-n) vergleicht und auf der Grundlage des Vergleichsergebnisses feststellt, ob die Speicherbatterien (101-1 bis 101-n) Fehlerkandidaten sind.

11. Speicherbatterievorrichtung nach einem der Ansprüche 1 bis 10, **dadurch gekennzeichnet, dass** die Speicherbatterie (101-1 bis 101-n) eine Lithiumionen-Sekundärbatterie ist.

12. Speicherbatterievorrichtung nach einem der Ansprüche 1 bis 11, **dadurch gekennzeichnet, dass** jede der Speicherbatterien eine Batteriegruppe ist, welche die mehreren in Reihe geschalteten Speicherbatterien aufweist.

13. Lade- und Entladeverfahren zum Laden und Entladen von Speicherbatterien in einer Speicherbatterievorrichtung mit mehreren Reihenkörpern (100-1, 100-2), die parallel geschaltet sind und mehrere in Reihe geschaltete Speicherbatterien (101-1 bis 101-n) und mehrere Transformatoren (102-1 bis 102-n) aufweisen, die jeweils einer entsprechenden der mehreren Speicherbatterien (101-1 bis 101-n) zugeordnet sind, jeweils eine Primärseite, die parallel zu der entsprechenden der mehreren Speicherbatterien (101-1 bis 101-n) geschaltet ist, und eine Sekundärseite, die parallel zum Reihenkörper (100-1, 100-2) geschaltet ist, aufweisen, die Eingangsspannung der Primärseite verstärken und die verstärkte Spannung an die Sekundärseite ausgeben, welches die folgenden Schritte aufweist:
Messen des Spannungswerts zwischen beiden Enden jeder der mehreren Speicherbatterien (101-1 bis 101-n),
Feststellen, ob die Speicherbatterien (101-1 bis 101-n) fehlerhaft sind, auf der Grundlage der gemessenen Spannungswerte,
Trennen der mehreren Transformatoren (102-1 bis 102-n) vom Reihenkörper (100-1) und Ausgeben der Reihenspannung der mehreren Speicherbatterien (101-1 bis 101-n) als Ausgangsspannung des Reihenkörpers (100-1), wenn es keine als fehlerhaft festgestellte Speicherbatterie gibt, und
Trennen der Speicherbatterie und des Transformators, der mit der Speicherbatterie verbunden ist, und Verstärken der Ausgangsspannung der von der fehlerhaften Batterie verschiedenen Speicherbatterien unter Verwendung der Transformatoren und Ausgeben der verstärkten Spannung als Ausgangsspannung des Reihenkörpers (100-1), wenn festgestellt wurde, dass eine Speicherbatterie fehlerhaft ist.

## Revendications

1. Dispositif de batterie de stockage incluant une pluralité de batteries de stockage (101-1 à 101-n), et incluant une pluralité de corps en série connectés en parallèle (100-1, 100-2), chacun étant constitué de multiples batteries de stockage (101-1 à 101-n) connectées en série, chacun des corps en série (100-1) comprenant :
une unité de mesure de tension (200) pour mesurer la valeur de tension entre les deux extrémités de chacune des multiples batteries de stockage (101-1 à 101-n),
une pluralité de transformateurs (102-1 à 102-n), chacun étant associé à l'une correspondante des multiples batteries de stockage (101-1 à 101-n), chacun ayant un côté primaire connecté en parallèle à l'une correspondante des multiples batteries de stockage (101-1 à 101-n) et un côté secondaire connecté en parallèle au corps en série (100-1), étant agencé pour augmenter la tension d'entrée du côté primaire et délivrer la tension augmentée au côté secondaire, et
une unité de commande (300) agencée pour déterminer si les batteries de stockage (101-1 à 101-n) sont ou non défectueuses sur la base des valeurs de tension mesurées par l'unité de mesure de tension (200) et, lorsqu'aucune batterie de stockage n'est déterminée comme étant défectueuse, déconnecter les multiples transformateurs (102-1 à 102-n) du corps en série (100-1) et délivrer la tension en série des multiples batteries de stockage (101-1 à 101-n) comme une tension de sortie du corps en série (100-1) et, lorsqu'une batterie de stockage est déterminée comme étant défectueuse, déconnecter la batterie de stockage et le transformateur qui est connecté à la batterie de stockage et augmenter la tension de sortie des batteries de stockage autres que la batterie défectueuse en utilisant les transformateurs et délivrer la tension augmentée comme tension de sortie du corps en série (100-1).

2. Dispositif de batterie de stockage selon la revendication 1, **caractérisé en ce que**
le corps en série (100-1) comprend :
un premier interrupteur de décharge (104) connecté en série aux batteries de stockage (101-1 à 101-n) ; et
une pluralité de deuxièmes interrupteurs de décharge (105-1 à 105-n), chacun étant connecté en série au côté primaire de chacun des multiples transformateurs (102-1 à 102-n),
au moment d'une décharge, l'unité de commande (300), lorsqu'aucune batterie de stockage n'est déterminée comme étant défectueuse, court-circuite le premier interrupteur de décharge (104) et ouvre tous les deuxièmes interrupteurs de décharge (105-1 à 105-n) et, lorsqu'une batterie de stockage est déterminée comme étant défectueuse, ouvre le premier interrupteur de décharge (104) et le deuxième interrupteur de décharge connecté au côté primaire du transformateur connecté à la batterie de stockage qui est déterminée comme étant défectueuse et court-circuite les deuxièmes interrupteurs de décharge connectés au côté primaire des transformateurs autres que le transformateur connecté à la batterie de stockage qui est déterminée comme étant défectueuse.

3. Dispositif de batterie de stockage selon la revendication 1 ou 2, **caractérisé en ce que**
le corps en série (100-1) comprend une pluralité d'interrupteurs de charge (106-1 à 106-n) connectés en parallèle à chacune des multiples batteries de stockage (101-1 à 101-n), et
l'unité de commande (300), au moment de la charge des batteries de stockage (101-1 à 101-n), court-circuite l'interrupteur de charge connecté à la batterie déterminée comme étant défectueuse et ouvre les interrupteurs de charge autres que celui-ci.

4. Dispositif de batterie de stockage selon la revendication 1, **caractérisé en ce que** le transformateur (102-1 à 102-n) peut augmenter ou réduire la tension dans les deux sens.

5. Dispositif de batterie de stockage selon la revendication 4, **caractérisé en ce que**
le corps en série (100-1) comprend un troisième interrupteur de décharge connecté en série aux batteries de stockage (101-1 à 101-n), une pluralité de quatrièmes interrupteurs de décharge, chacun étant connecté en série au côté primaire de chacun des multiples transformateurs (102-1 à 102-n), et une pluralité de cinquièmes interrupteurs de décharge, chacun étant connecté en série au côté secondaire de chacun des multiples transformateurs (102-1 à 102-n),
l'unité de commande (300), lorsqu'aucune batterie de stockage n'est déterminée comme étant défectueuse, court-circuite le troisième interrupteur de décharge et ouvre tous les quatrièmes interrupteurs de décharge et les cinquièmes interrupteurs de décharge et, lorsqu'une batterie de stockage est déterminée comme étant défectueuse, ouvre le troisième interrupteur de décharge et le quatrième interrupteur de décharge et le cinquième interrupteur de décharge qui sont respectivement connectés au côté primaire et au côté secondaire du transformateur connecté à la batterie de stockage déterminée comme étant défectueuse et court-circuite les quatrièmes interrupteurs de décharge et les cinquièmes interrupteurs de décharge connectés au côté primaire et au côté secondaire des transformateurs autres que le transformateur connecté à la batterie de stockage déterminée comme étant défectueuse.

6. Dispositif de batterie de stockage selon la revendication 1, **caractérisé en ce que** le rapport de la tension de sortie du côté secondaire sur la tension d'entrée du côté primaire est le nombre de batteries appartenant à un corps en série (100-1, 100-2)

7. Dispositif de batterie de stockage selon l'une quelconque des revendications 1 à 6, **caractérisé en ce que** l'unité de commande (300) compare la valeur de tension mesurée par l'unité de mesure de tension (200) à une valeur de seuil prédéterminée et détermine si la batterie est ou non défectueuse sur la base du résultat de comparaison.

8. Dispositif de batterie de stockage selon l'une quelconque des revendications 1 à 7, **caractérisé en ce que** l'unité de commande (300) compare les valeurs de tension des multiples batteries de stockage (101-1 à 101-n) mesurées par l'unité de mesure de tension (200) et détermine si les batteries de stockage (101-1 à 101-n) sont ou non défectueuses sur la base du résultat de comparaison.

9. Dispositif de batterie de stockage selon la revendication 3, **caractérisé en ce que** l'unité de commande (300), au moment de la charge des batteries de stockage (101-1 à 101-n), détermine si les batteries de stockage (101-1 à 101-n) sont ou non des candidates défectueuses sur la base des valeurs de tension mesurées par l'unité de mesure de tension (200), et court-circuite l'interrupteur de charge connecté à la batterie de stockage détectée comme candidate défectueuse et ouvre les interrupteurs de charge autres que celui-ci.

10. Dispositif de batterie de stockage selon la revendication 9, **caractérisé en ce que** l'unité de commande (300) compare les valeurs de tension des multiples batteries de stockage (101-1 à 101-n) mesurées par l'unité de mesure de tension (200) et détermine si les batteries de stockage (101-1 à 101-n) sont ou non des candidates défectueuses sur la base du résultat de comparaison.

11. Dispositif de batterie de stockage selon l'une quelconque des revendications 1 à 10,
**caractérisé en ce que** la batterie de stockage (101-1 à 101-n) est une batterie secondaire lithium-ion.

12. Dispositif de batterie de stockage selon l'une quelconque des revendications 1 à 11,
**caractérisé en ce que** chacune des batteries de stockage est un groupe de batteries comprenant les multiples batteries de stockage connectées en série.

13. Procédé de charge et de décharge pour charger et décharger des batteries de stockage dans un dispositif de batterie de stockage comprenant une pluralité de corps en série (100-1, 100-2) connectés en parallèle et comprenant une pluralité de batteries de stockage (101-1 à 101-n) connectées en série et une pluralité de transformateurs (102-1 à 102-n), chacun étant associé à l'une correspondante des multiples batteries de stockage (101-1 à 101-n), chacun ayant le côté primaire connecté en parallèle à celle correspondante des multiples batteries de stockage (101-1 à 101-n) et le côté secondaire connecté en parallèle au corps en série (100-1, 100-2), augmentant la tension d'entrée du côté primaire et délivrant la tension augmentée au côté secondaire, comprenant les étapes de :
mesurer la valeur de tension entre les deux extrémités de chacune des multiples batteries de stockage (101-1 à 101-n) ;
déterminer si les batteries de stockage (101-1 à 101-n) sont ou non défectueuses sur la base des valeurs de tension mesurées ;
déconnecter les multiples transformateurs (102-1 à 102-n) du corps en série (100-1) et délivrer la tension en série des multiples batteries de stockage (101-1 à 101-n) comme tension de sortie du corps en série (100-1) lorsqu'aucune batterie de stockage n'est déterminée comme étant défectueuse ; et,
déconnecter la batterie de stockage et le transformateur connecté à la batterie de stockage et augmenter la tension de sortie des batteries de stockage autres que la batterie défectueuse en utilisant les transformateurs et délivrer la tension augmentée comme tension de sortie du corps en série (100-1) lorsqu'une batterie de stockage est déterminée comme étant défectueuse.
